(19) Europäisches Patentamt
European Patent Office
Office européen des brevets

(11) **EP 2 919 966 B1**

(12) **EUROPÄISCHE PATENTSCHRIFT**

(45) Veröffentlichungstag und Bekanntmachung des Hinweises auf die Patenterteilung:
**14.10.2020 Patentblatt 2020/42**

(21) Anmeldenummer: **13783257.2**

(22) Anmeldetag: **24.10.2013**

(51) Int Cl.:
*B29C 59/02* (2006.01)     *B08B 17/06* (2006.01)
*B29C 37/00* (2006.01)     *B01D 17/02* (2006.01)
*B01J 20/26* (2006.01)     *B01J 20/28* (2006.01)
*B01J 20/30* (2006.01)

(86) Internationale Anmeldenummer:
**PCT/EP2013/003199**

(87) Internationale Veröffentlichungsnummer:
**WO 2014/075761 (22.05.2014 Gazette 2014/21)**

(54) **VERFAHREN ZUR HERSTELLUNG EINES FORMKÖRPERS MIT SUPERHYDROPHOBER OBERFLÄCHE**

METHOD FOR PRODUCING A SHAPED BODY HAVING A SUPERHYDROPHOBIC SURFACE

PROCÉDÉ DE FABRICATION D'UN ÉLÉMENT FAÇONNÉ POSSÉDANT UNE SURFACE SUPERHYDROPHOBE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.11.2012 DE 102012111089**
**04.09.2013 DE 102013109621**

(43) Veröffentlichungstag der Anmeldung:
**23.09.2015 Patentblatt 2015/39**

(73) Patentinhaber: **Karlsruher Institut für Technologie**
**76131 Karlsruhe (DE)**

(72) Erfinder:
• **RÖHRIG, Michael**
**76669 Bad Schönborn (DE)**
• **HÖLSCHER, Hendrik**
**76356 Weingarten (DE)**
• **SCHNEIDER, Marc**
**76356 Weingarten (DE)**
• **WORGULL, Matthias**
**76297 Stutensee (DE)**
• **HOPF, Andreas**
**76131 Karlsruhe (DE)**

(56) Entgegenhaltungen:
WO-A1-2012/024099     WO-A1-2012/058090
DE-A1- 2 512 772     DE-A1-102008 053 619
DE-A1-102008 057 346     US-A1- 2010 326 922

EP 2 919 966 B1

**Beschreibung**

Die Erfindung betrifft ein Verfahren zur Herstellung eines Formkörpers.

Die Frage der Benetzbarkeit einer Oberfläche mit Wasser bildet die Basis für viele technische Lösungen in den Bereichen Dichtungen, selbstreinigende Oberflächen oder Trinkwassergewinnung. Hierfür hat die Natur bereits vielfältige Lösungen entwickelt, die oftmals aus einer Strukturierung bzw. einer ausgewählten chemischen Zusammensetzung der natürlichen Oberfläche resultieren.

Eines der bekanntesten Beispiele hierfür ist die Lotuspflanze, deren Blätter nach W. Barthlott und C. Neinhuis, Purity of the sacred lotus, or escape from contamination in biological surfaces, Planta 202, 1 (1997), mit mikrometergroßen Papillen besetzt sind, auf denen sich eine epicuticulare Wachsschicht befindet. Durch eine geeignete Kombination aus Strukturierung und Oberflächenchemie ergibt sich eine geringe Benetzbarkeit der Blätter der Lotuspflanze mit Wasser, worauf die berühmte Fähigkeit der Lotuspflanze zur Selbstreinigung basiert.

B. Bhushan und E.K. Her, Fabrication of Superhydrophobic Surfaces with High and Low Adhesion Inspired from Rose Petal, Langmuir 26(11), 8207 (2010) beschreiben, dass einige Rosenarten einen gegenteiligen Effekt besitzen. Diese Rosen haben auf ihren Blüten eine Oberfläche entwickelt, die eihe große Menge Wasser speichern kann. Obwohl diese Oberflächen ähnlich wie die der Lotuspflanze mit einer feinen Wachsschicht belegt sind, führt eine davon abweichende Anordnung der darunter liegenden Mikrostruktur jedoch dazu, dass die Wassertropfen von den Rosenblütenblätternquasi festgehalten werden.

Nach A.R. Parker und C.R. Lawrence, Water capture by a desert beetle, Nature 414, 33 (2001), macht sich der Namibische Wüstenkäfer die Benetzbarkeit durch Wasser in besonderem Maße zu Nutzen. Um in der heißen Wüste genügend Wasser aufnehmen zu können, streckt er bei aufkommendem Nebel seine Flügel, die mit mikrometergroßen hydrophilen Erhebungen und hydrophoben Mulden bedeckt sind, in die feuchte Umgebung, woraufhin der Nebel an den Flügeln kondensiert und Tropfen formt, die, nachdem sie eine gewisse Größe erreicht haben, direkt in den Mund des Käfers laufen.

Um auf technische Weise superhydrophobe Oberflächen herzustellen, setzen J. Bekesi, J.J.J. Kaakkunen, W. Michaeli, F. Klaiber, M. Schoengart, J. Ihlemahn und P.Simon, Fast fabrication of super-hydrophobic surfaces on polypropylene by replication of shortpulse laser structured molds, Appl. Phys. A 99, 691 (2010), ein Spritzgussverfahren ein, wozu regelmäßig angeordnete Strukturen dienen, deren Bereitstellung eine spezielle und teure Formeinsatzerzeugung erforderlich macht. Um die Strukturen oder deren Funktion zu ändern, ist die aufwändige Herstellung eines neuen Formeinsatzes erforderlich. Um Hinterschnitte zu erzeugen, müssen die Formeinsätze anschließend mittels eines zusätzlichen Verfahrensschrittes, insbesondere durch Laserablation, nachbearbeitet werden. Schließlich ist die damit erzielte Steigerung des Kontaktwinkels gering.

Die DE 10 2008 053 619 A1 offenbart ein Verfahren zur Herstellung eines technischen Formkörpers. Hierzu werden eine Schicht eines aushärtbaren Kunststoffs zwischen zwei parallele, wärmeleitfähige. Platten eingebracht, ein Pressdruck zwischen die beiden Platten angelegt und die beiden Platten aufgeheizt, so dass die Schicht auf eine Temperatur oberhalb des Glaspunkts des Kunststoffs erwärmt wird. Die beiden Platten unterscheiden sich dadurch, dass sie auf ihrer Oberfläche eine unterschiedliche Adhäsionskraft oder *Rauheit* aufweisen oder sie auf zwei verschiedene Temperaturen erhitzt werden. Anschließend werden die beiden Platten unter Beibehaltung der Temperatur auseinander gezogen, wodurch die Schicht an einer der beiden Platten haften bleibt, während sich an der anderen Platte eine Vielzahl von ersten Fäden ausbildet. Nach Aushärten des Kunststoffs wird ein Substrat, auf das eine Vielzahl von ersten Fäden aufgebracht ist, erhalten und zwischen zwei parallele, wärmeleitfähige Platten eingebracht. Nach Anlegen eines Pressdrucks und Aufheizen der beiden Platten auf eine Temperatur oberhalb des Glaspunkts werden die beiden Platten unter Beibehaltung der Temperatur auseinander gezogen, wodurch das Substrat an einer der beiden Platten haften bleibt, während sich an der anderen der beiden Platten eine Vielzahl von zweiten Fäden, deren Unterseiten jeweils fest mit der Oberfläche jedes ersten Fadens verbunden ist, ausbildet.

Der Begriff der *Rauheit* bezeichnet gemäß U. Fischer et al., Tabellenbuch Metall, 41. neubearbeitete und erweiterte Auflage, Verlag Europa-Lehrmittel, Haan-Gruiten (2002) eine Form der Gestaltabweichung, hervorgerufen durch Abweichungen der Ist-Oberfläche (messtechnisch erfassbare Oberfläche) von der geometrisch idealen Oberfläche, deren Nennform durch eine Zeichnung definiert ist. Eine solche Unebenheit einer Oberflächenhöhe wird messtechnisch erfasst und mittels der Parameter der *mittleren Rauheit* $R_a$ und der. *gemittelten Rautiefe* $R_z$ zahlenmäßig charakterisiert. Diese Rauheitskenngrößen werden nach W. Beitz und K.-H. Grote, Dubbel Taschenbuch für den Maschinenbau,19. Auflage, Springer-Verlag Berlin (1997) ausgehend von der Bezugsoberfläche erfasst, die im Regelfall die Form der geometrischen Oberfläche hat und in ihrer Lage im Raum mit der Hauptrichtung der wirklichen Oberfläche übereinstimmt.

Der Parameter der *mittleren Rauheit* $R_a$ entspricht dem arithmetischen Mittel der Abweichung eines Messpunktes auf der Oberfläche von der Mittellinie. Der Parameter der *gemittelten Rautiefe* $R_z$ wird ermittelt, indem eine definierte Messstrecke auf der Oberfläche des Werkstücks in sieben gleich große Einzelmessstrecken eingeteilt wird, wobei die Auswertung nur über fünf dieser Strecken erfolgt. Von jeder der Einzelmessstrecken wird die Differenz aus maximalem und minimalem Wert ermittelt und hieraus abschließend der Mittelwert gebildet.

Die Separation von Öl-Wässer Emulsionen stellt eine große technische Herausforderung dar. Insbesondere durch Umweltkatastrophen auf offener See rückt die Beseitigung von Ölteppichen immer wieder in den Fokus.

Zur Beseitigung eines Ölteppichs auf hoher See stehen grundsätzlich drei Möglichkeiten zur Verfügung:

- das Abschöpfen des Öls,
- die Beschleunigung der natürlichen Zersetzung des Öls durch Zugabe von Dispergiermitteln,
- sowie die Verbrennung des Ölfilms auf dem offenen Meer.

Unter Durchführung der beiden letztgenannten Möglichkeiten ist keine fachgerechte Entsorgung des Öls möglich, priorisieren Juuso T. Korhonen, Marjo Kettunen, Robin H. A. Ras and Olli Ikkala, Hydrophobic nanocellulose aero-gels as floating, sustainable, reusable, and recyclable oil absorbents, ACS Appl. Mater. Interfaces, 3 (6) :1813-1816, 2011, das Abschöpfen des Öls. Um die aufwändige Aufbereitung des abgeschöpften Öl-Wasser-Gemischs zu vermeiden, müssen selektive Sorbenzien eingesetzt werden. Üblicherweise werden hierzu natürliche Absorbenzien herangezogen. Als natürliche Absorbenzien dienen beispielsweise Sägespäne, Reisstroh oder Baumwolle. Diese saugen zwar, wenn auch in recht geringem Maße, Öl auf, jedoch wird ihre Einsatzfähigkeit durch eine schiechte Schwimmfanigkeit und vor allem aufgrund ihrer ausgeprägten Neigung zur Wasseraufnahme stark eingeschränkt wie es A. Venkateswara Rao, Nagaraja D. Hegde and Hiroshi Hirashima, Absorption and desorption of organic liquids in elastic superhydrophobic silica aerogels, Journal of Colloid and Interface Science, 305(1):124 - 132, 2007 zeigt. Neben ihrer geringen Aufnahmefähigkeit, liegt also der große Nachteil dieser hydrophilen Absorbenzien darin, dass sie neben Öl auch eine beachtlichen Menge Wasser absorbieren. Dies macht eine Wiederaufbereitung der absorbierten Flüssigkeiten notwendig. Hierzu werden aufwendige Techniken wie beispielsweise Sedimentation, Flotation oder Zentrifugation nachgeschalten. Diese Methoden können Emulsionen allerdings erst ab einer gewissen Partikelgröße auftrennen. Für Partikelgrößen unter 150 $\mu$m sind sie lediglich begrenzt einsetzbar. Xinwei Chen, Liang Hong, Yanfang Xu and Zheng Wei Ong, Ceramic pore channels with inducted car-bon nanotubes for removing oil from water, ACS Applied Materials & Interfaces, 4(4):1909-1918, 2012 nutzen hierzu komplexe Methoden auf Basis von Kohlenstoffnanoröhrchen. Um eine derart aufwändige Aufbereitung abgeschöpfter Flüssigkeit zu vermeiden, sind Sorbenzien gefordert, die Wasser abweisen und somit selektiv Öl aufnehmen.

Solche Sorbenzien beruhen auf mineralischer Basis. Mineralische Absorbenzien wie Zeolith oder Silica-Schäume sind zunächst einmal amphiphil (hydrophil' und lipophil). M.O. Adebajo, R.L. Frost, J.T. Kloprögge, O. Carmody and S. Kokot, Porous materials for oil spill cleanup: A review of synthesis and absorbing properties, Journal of Porous Materials, 10:159-170, 2003 zeigt eine geeignete Behandlung, die diese Absorbenzien hydrophobisiert, wodurch das Eindringen von Wasser in die Mikro- und Nanoporen verhindert werden soll. Wie allgemein geläufig stehen bei mineralischen Absorbenzien jedoch der hohen Ölaufnahmefähigkeit folgende negative Eigenschaften gegenüber: hohe Entflammbarkeit, hohe SprödigKeit und eine nicht permanent aufrechtzuerhaltende Hydrophobizität. Sollte Wasser in die Schäume eindringen, was für den Einsatz im Meer aufgrund von Strömung bzw. Wellengang nicht zu verhindern ist, kollabieren diese Absorbenzien in aller Regel. Weitere auf dem Markt und in der Forschung verfügbare Sorbenzien sind synthetische organische Absorbenzien wie kommerziell erhältliche Polypropylen- oder Polyurethan-Matten, die diese Lücke zu schließen scheinen. Sie zeichnen sich zunächst durch eine rasche und hohe Ölaufnahme aus. Die Wasseraufnahme ist gering, aber dennoch vorhanden. Bei der Entnahme dieser Matten aus dem Wasser wird jedoch eine Schwachstelle sichtbar: die Rückhaltung des Öls ist stark beschränkt.

Dies hat zur Folge das bei der Entnahme der Matten ca. 50% des aufgefangen Öls in das Meer zurückfließt.

Demnach erfüllt das Gros der erhältlichen Absorbenzien nicht die erfoderliche Hydrophobizität. Neben Öl wird zusätzlich Wasser, teils in sehr hohem Ausmaß, aufgenommen. Die selektive Aufnahme von Öl ist sowohl bei natürlichen als auch mineralischen Absorbenzien nicht ausreichend gewährleistet. Die Wasseraufnahme kann unter Umständen sogar zur vollständigen Zerstörung des Absorbens durch Strukturkollaps führen. Die organischen Absorbenzien haben hier Vorteile, sind jedoch in ihrer Rückhaltefähigkeit begrenzt. Bis zu 50% des absorbierten Öls wird bei der Entnahme der Absorbenzien aus dem Wasser wieder an das Meer abgegeben.

Ausgehend hiervon ist es die Aufgabe der vorliegenden Erfindung, ein Verfahren zur Herstellung eines Formkörpers vorzuschlagen, die die vorher genannten Nachteile und Einschränkungen nicht aufweisen.

Insbesondere soll ein Verfahren bereitgestellt werden, mit dem sich auf möglichst einfache Weise superhydrophobe Oberflächen für eine Vielzahl von technischen Anwendungen herstellen lassen, wobei sich Art und Grad der Haftung der Oberfläche zu Wasser mittels ausgewählter Verfahrensparameter einstellen lassen.

Diese Aufgabe wird durch die Verfahrensschritte des Anspruchs 1 gelöst. Die abhängigen Ansprüche beschreiben vorteilhafte Ausgestaltungen der Erfindung.

Erfindungsgemäß wird ein Formkörper hergestellt, der eine superhydrophobe Oberfläche aus einem Polymer aufweist, die mittels eines besonders ausgestalteten Umformverfahrens erhältlich ist. Das eingesetzte Polymer selbst kann hydrophilen oder hydrophoben Ursprungscharakter aufweisen. Die Oberfläche des Formkörpers weist eine Kraterstruktur mit Kratern mit einem mittleren Durchmesser von 2 $\mu$m bis 250 $\mu$m und einer Höhe von 1 $\mu$m bis 500 $\mu$m auf, auf deren Oberkanten Polymerhärchen mit einer Länge von 0,5 $\mu$m bis 200 $\mu$m ausgebildet sind.

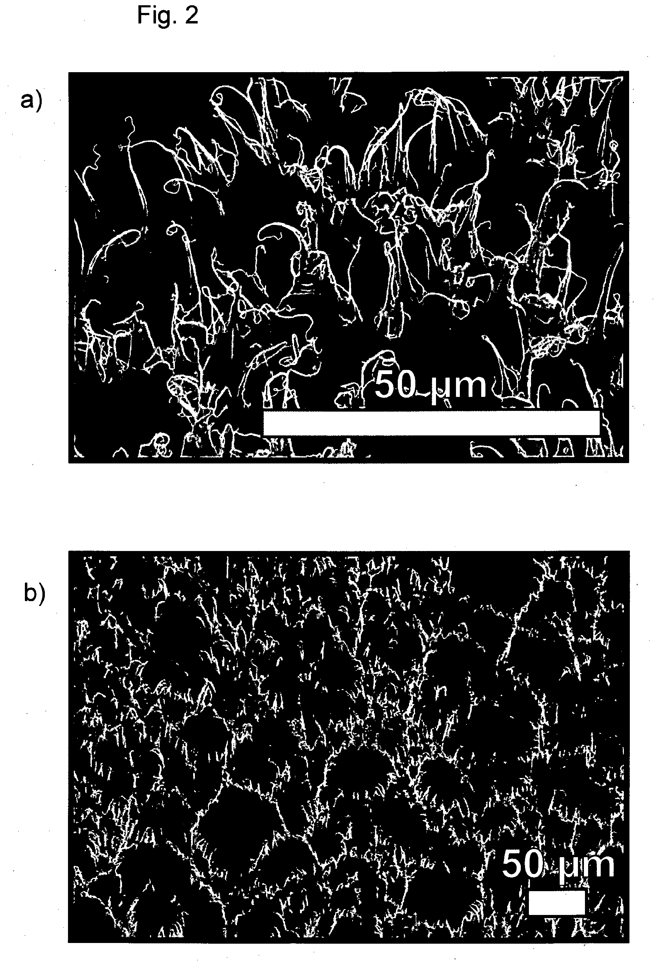

In einer ersten Ausgestaltung entspricht die Länge der Polymerhärchen dem 0,5-fachen bis 10-fachen der mittleren Durchmesser der Krater (siehe **Fig. 2a und b))**. Wie sich aus damit durchgeführten Versuchen ergab, weisen diese Strukturen einen weitgehend vollständig wasserabweisenden Charakter auf und ahmen durch ihre geometrische Ausprägung den Lotuseffekt nach.

In einer zweiten Ausgestaltung entspricht die Länge der Polymerhärchen dem 0,01-fachen bis 0,5-fachen der mittleren Durchmesser der Krater (siehe **Fig: 2c))**. Wie sich aus durchgeführten Versuchen ergab, ermöglichen diese Strukturen als Funktion der Dichte der Krater zusammen mit der Dichte der sich auf der Oberkante der Krater befindlichen Polymerhärchen keine oder eine hohe Haftung der Oberfläche des Formkörpers insbesondere zu Wasser. Bei geeigneter Wahl dieser Funktion lassen sich damit auf der Oberfläche des Formkörpers Strukturen ausbilden, die in der Lage sind, Wassertropfen festzuhalten.

Der Formkörper ist erhältlich durch ein erfindungsgemäßes Verfahren, das die Verfahrensschritte a) bis d) umfasst.

In einem ersten **Verfahrensschritt a)** wird zunächst ein Verbund zwischen einer ersten Platte und einer Polymerfolie bereitgestellt. Unter einer Polymerfolie wird hier ein ebenes und ausgedehntes Gebilde aus einem Polymer, insbesondere ein thermoplastischen Polymer (Thermoplast), verstanden, das eine Dicke von 1 $\mu$m bis 10 cm, bevorzugt von 250 $\mu$m bis 2mm, aufweist.

Die Herstellung des Verbunds aus der ersten Platte und der Polymerfolie erfolgt vorzugsweise, indem hierzu zunächst die Polymerfolie zwischen die erste Platte und eine zweite Platte eingelegt wird. In der Praxis besitzt stets eine der beiden Platten (erste Platte) eine höhere Haftung zum Polymer, während die andere der beiden Platten (zweite Platte) eine geringere Haftung zum Polymer aufweist, insbesondere dann, wenn sie bereits eine polierte oder geschliffene Oberfläche besitzt, oder indem eine Trennschicht zwischen ihr und der Polymerfolie eingelegt wird. Um den Verbund aus der Polymerfolie mit der ersten, gut haftenden Platte zu erzeugen, werden anschließend vorzugsweise beide Platten auf eine Temperatur oberhalb der Glasübergangstemperatur $T_g$ des in der Polymerfolie enthaltenen Polymers erhitzt, wobei das erweichte Polymer durch ein Aufbringen einer Prägekraft derart an die erste Platte gepresst wird, dass dadurch der Verbund aus der Polymerfolie mit der ersten Platte gebildet und abschließend Polymerverbund und Gegenplatte voneinander getrennt wird.

In einem zweiten **Verfahrensschritt b)** wird eine dritte Platte bereitgestellt, die Rauheiten besitzt, die über eine mittlere Rauheit $R_a$' von 1 $\mu$m bis 20 $\mu$m, bevorzugt von 8 $\mu$m bis 15 $\mu$m, und über eine gemittelte Rautiefe $R_z$' von 30 $\mu$m bis 100 $\mu$m, bevorzugt von 40 $\mu$m bis 50 $\mu$m, verfügen. Das Erzeugen der erforderlichen Rauheiten erfolgt vorzugsweise durch eine Einwirkung von Partikeln, bevorzugt Sandstrahlen, auf mindestens einer Seite der dritten Platte.

In einem dritten **Verfahrensschritt c),** der den eigentlichen Umformschritt darstellt, werden an der Oberfläche der Polymerfolie die oben.beschriebenen gewünschten Strukturen erzeugt. Die dritte Platte dient im Umformverfahren als Formeinsatzplatte und wird demgemäß gegenüber dem in Verfahrensschritt a) erzeugten Verbund aus der ersten Platte und der Polymerfolie platziert, ohne bereits jetzt den Verbund zu berühren. Hieran anschließend wird die dritte Platte über die Glasübergangstemperatur $T_g$ des in der Polymerfolie enthaltenden Polymers erwärmt, wobei der Verbund aus der ersten Platte und der Polymerfolie selbst nicht erwärmt wird. Tritt daraufhin die nun heiße dritte Platte in ihrer Eigenschaft als Formeinsatzplatte unter Krafteinwirkung mit der Polymerfolie in Kontakt, wird das Polymer aus der Polymerfolie teilweise in die bestehenden Rauheiten der dritten Platte eingepresst.

In einem vierten **Verfahrensschritt d)**, der den Entformvorgang darstellt, wird die der dritten Platte zugewandte andere Oberfläche der Polymerfolie durch eine Relativbewegung zwischen der ersten Platte aus dem Verbund und der als Formeinsatzplatte dienenden dritten Platte strukturiert, solange die Polymerfolie, die sich im Verbund mit der ersten Platte befindet und daher durch die Relativbewegung mit erfasst wird, während des Entformvorgangs weiterhin erweicht bleibt, d.h. solange ihre Temperatur ungefähr der Glasübergangstemperatur entspricht, und sich hierdurch in die Länge ziehen lässt. Die Richtung der Relativbewegung ist hierbei im Wesentlichen antiparallel zur Richtung der Krafteinwirkung und senkrecht oder schräg bzgl. der mittleren Oberfläche der ersten Platte, einschließlich der damit im Verbund stehenden Polymerfolie, und der dritten Platte.

Die genaue geometrische Ausprägung der Strukturen wird hierbei durch eine fachmännisch geläufige Wahl eines Parametersatzes, der die folgenden Parameter

- *Temperatur,* auf die die dritte Platte während des Verfahrensschritts b) erwärmt wird,
- *Rauheit* der dritten Platte,
- *Höhe der Kraft,* mit der die heiße dritte Platte während des Verfahrensschritts b) in ihrer Eigenschaft als Formeinsatzplatte mit der Polymerfolie in Kontakt tritt,
- *Haltezeit,* während der die Kraft auf Polymerfolie einwirkt, und
- *Entformgeschwihdigkeit,* mit der die Relativbewegung zwischen der ersten Platte aus dem Verbund und der als Formeinsatzplatte dienenden dritten Platte erfolgt,

umfasst, eingestellt.

Abhängig vom gewählten Parametersatz, insbesondere bei einer Temperatur unterhalb des Schmelzbereichs des Polymers, erfolgt ein vorzugsweise rückstandsfreies Entformen (*Ziehen*) der eingepressten Polymerfolie von der noch erwärmten dritten Platte, wodurch dichte, feine Polymerhärchen gezogen werden (siehe **Fig. 2a),** die in Form einer Kraterstruktur angeordnet sind. (siehe **Fig. 2b**). Durch ihre Art der geometrischen Ausprägung ahmen diese Strukturen den Lotuseffekt nach.

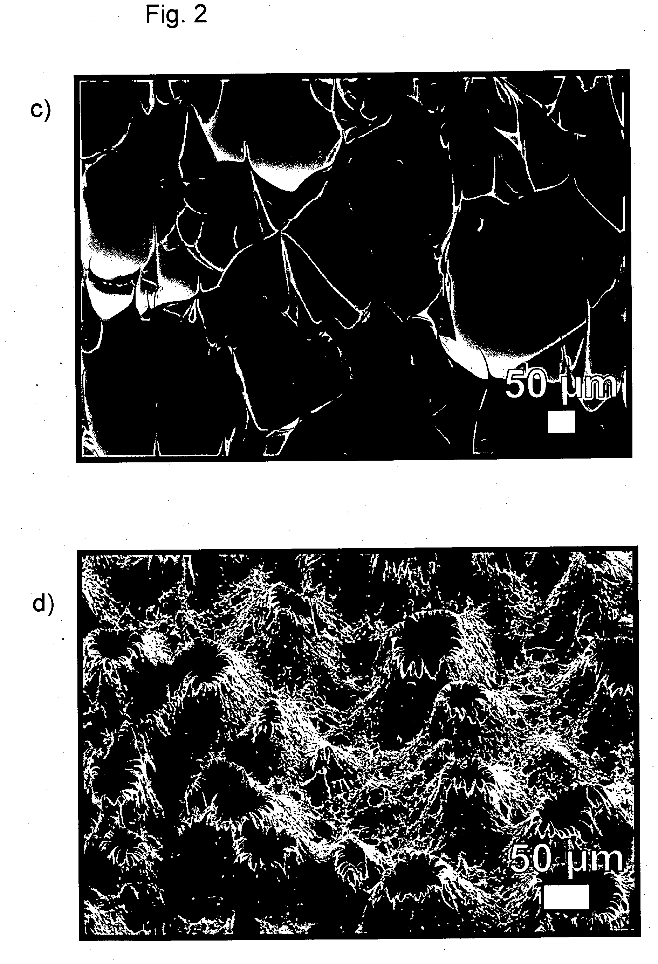

Bei einem anders gewählten Parametersatz, insbesondere bei einer Temperatur im Schmelzbereich des Polymers, führt ein Entformen der eingepressten Polymerfolie von der noch erwärmten dritten Platte zu einem *Auseinanderreißen* der Polymerschicht, wodurch feine Krater erzeugt werden, an deren Oberkante sich kleinste Polymerhärchen befinden (siehe **Fig. 2c**). Diese Strukturen ermöglichen als Funktion der Dichte der Krater zusammen mit der Dichteder sich auf der Oberkante der Krater befindlichen Polymerhärchen eine hohe Haftung der geformten Polymerschicht insbesondere zu Wasser.

Bei einem weiteren Parametersatz, insbesondere bei einer Temperatur, die zwischen den bisher beschriebenen Ausgestaltungen liegt, werden beim Entformen Krater erzeugt, an deren Oberkante sich längere Polymerhärchen befinden (siehe **Fig. 2d**), die im Vergleich zu einem mittleren Grad an Haftung der geformten Polymerschicht insbesondere zu Wasser führen.

In einer alternativen Ausgestaltung sind die im vorliegenden Verfahren eingesetzte erste Platte und/oder zweite Platte und/ oder dritte Platte in Form einer Walze ausgestaltet. Eine derartige Ausgestaltung ermöglicht einen erheblich höheren Durchsatz bei der praktischen Durchführung des vorliegenden Verfahrens.

Ein gemäß der Offenbarung ausgestalteter Formkörper lässt sich überall dort verwenden, wo Oberflächen gewollt oder ungewollt mit Wasser oder Feuchtigkeit bzw. wasser- oder feuchtigkeitsbasierten Stoffen oder Ölen oder ölhaltigen Flüssigkeiten in Kontakt kommen.

Ein erster Einsatzbereich sind selbstreinigende Oberflächen, die sich für eine Vielzahl von Produkten eignen, insbesondere für sterile Medizingeräten, im Laborbedarf, in der Lebensmittelindustrie, bei Plastikgeschirr, Vorratsdosen, Backformen und -papier, für schmutzabweisende Kleidung, bei selbstreinigenden Dachziegeln oder für vollständig entleerbare Klebeflaschen. Zu diesem Bereich gehören auch wasserabweisende Oberflächen, vorzugsweise in Dichtungen, als Anti-Beschlag, bevorzugt für Brillengläser, als Korrosionsschutz, indem ein Kontakt des Wassers mit der Oberfläche verhindert wird, als wasserabweisende Kleidung oder als innenstrukturierte Schläuche zur Verringerung der Reibung bzw. der Veränderung der Strömungseigenschaften.

Ein zweiter Einsatzbereich ist die Lufthaltung, insbesondere als Korrosionsschutz unter Wasser, als Beschichtung für Schiffsrümpfe zur Verringerung der Reibung in Wasser, zur Reibungsminimierung im Wasser durch Lufthaltung der Strukturen mit dem Zweck der Treibstoffersparnis in der Schifffahrt.

Ein weiterer Einsatzbereich ist die Wasserhaltung, insbesondere zum Zurückhalten von Kondenswasser, bevorzugt in Räumen oder Flugzeugen, um einen Niederschlag des Kondenswassers in Passagierbereichen zu verhindern, als Wasserauffangbehälter, in Kinder-Lätzchen oder Windeln. Zu diesem Bereich gehört auch die Trinkwassergewinnung, insbesondere ein sog. *Water-Harvesting* nach dem Vorbild des eingangs genannten namibischen Wüstenkäfers, Zelte, die auch in trockenen Regionen Wasser der feuchten Umgebungsluft entziehen, oder die Bewässerungslandwirtschaft.

Ein weiterer Einsatzbereich sind die kanalfreie Mikrofluidik und *Lab-on-a-chip* Systeme, bei denen Tröpfchen mittels hydrophiler und/oder hydrophober Bereiche in einem Kanal bzw. über eine Oberfläche geführt werden.

Der gemäß der Offenbarung ausgestaltete Formkörper findet weiterhin Verwendung als Trennungsmedium mindestens einer unpolaren Flüssigkeit und mindestens einer polaren Flüssigkeit. Zur Durchführung der Trennung wird zunächst ein Formkörper bereitgestellt, der zumindest teilweise eine gleichzeitig superhydrophobe und superlipophile nanostrukturierte Oberfläche aufweist. Durch die Nanostrukturierung ist die Oberfläche fähig mehr Öl aufzunehmen. Anschließend wird der Formkörper mit der zumindest teilweise superhydrophoben nanostrukturierten Oberfläche mit einer Mischung in Kontakt gebracht, umfassend mindestens eine unpolare Flüssigkeit und mindestens eine polare Flüssigkeit, die zu trennen sind. Dabei wird die unpolare Flüssigkeit auf der superhydrophoben nanostrukturierten Oberfläche des Formkörpers aufgenommen. Zum Schluss wird der Formkörper mit der superhydrophoben nanostrukturierten Oberfläche, auf die zumindestens teilweise die unpolare Flüssigkeit aufgenommen wurde, entnommen.

Um die Benetzbarkeit einer Flüssigkeit bei Kontakt mit einer Oberfläche einzuschätzen wird der sogenannte Spreitparameter S ermittelt, der die Differenz zwischen der Oberflächenspannung des Substrats $\gamma_{SV}$, der Oberflächenspannung der Flüssigkeit $\gamma_{LV}$ und der Grenzflächenspannung zwischen Substrat und Flüssigkeit. $\gamma_{SL}$ beschreibt:

$$S = \gamma_{SV} - ( \gamma_{LV} + \gamma_{SL} )$$

Im Falle eines positiven Spreitparameters S > 0, benetzt die Flüssigkeit das Substrat vollständig und bildet einen dünnen Film an dessen Oberfläche. Ist der Spreitparameter negativ benetzt die Flüssigkeit das Substrat nur partiell. Je kleiner der Spreitparameter, desto grösser die Benetzbarkeit der Oberfläche. Kontaktwinkel θ der entstehenden Tropfen unter 90° bedeuten benetzbare Oberflächen, während Kontaktwinkel über 90° unbenetzbaren Oberflächen entsprechen. Benutzt man θ=90° als Randbedingung, ergibt die Youngsche Gleichung, $\gamma_{SL} = Y_{SV}$ und der Spreitparameter $S_b$, der die Grenze zwischen Benetzbarkeit und Unbenetzbarkeit darstellt, ist gleich - $\gamma_{LV}$.

Wenn die Grenzflächenspannungen für die Grenzflächen zwischen Substrat/Gas und zwischen Flüssigkeit/Gas bekannt sind, lässt sich nach D. K. Owens and R. C. Wendt, Estimation of the surface free energy of polymers, Journal of Applied Polymer Science, 13(8):1741-1747, 1969, die entsprechende Grenzflächenspannung für die Grenzfläche zwischen Substrat/Flüssigkeit herausfinden, wobei d und p für die disperse bzw. die polare stehen. Demnach reicht es aus, die Oberflächenspannung vom Substrat und die Oberflächenspannung von der Flüssigkeit zu kennen, um den Spreitparameter S zu bestimmen und die Benetzbarkeit vorherzusagen.

Daraus wird als superhydrophob eine äußerst hydrophobe Oberfläche definiert, die sehr schwer benetzbar ist, d.h. bei der die entsprechenden Kontaktwinkel eines Wassertropfens grösser als 150° sind.

Als superhydrophil wird eine Oberfläche bezeichnet, die vollständig mit Wasser benetzbar ist, wobei der Spreitparameter S > 0 ist. Analog dazu ist ein superlipophiles Material so lipophil oder ölaffin, dass sich das Öl komplett auf der Oberfläche verteilt bis zur vollständigen Benetzung mit mindestens einer Monolage.

In einer besonderen Ausgestaltung ist der Formkörper eine Folie. Bereits bekannte Adsorbenzien sind entweder Granulate, Aerogel, Schäume oder filzartige Matten. Öl wird nach erfolgreicher Trennung von Wasser durch das erfindungsgemäße Verfahren deutlich leichter von der Folie getrennt und anschließend entsorgt als dies bei den bekannten Absorbenzien der Fall ist. In einer besonderen Ausgestaltung weist die zumindest teilweise superhydrophobe nanostrukturierte Oberfläche eine Kraterstruktur auf, wobei auf der Oberkante der Krater Härchen ausgebildet sind.

Vorzugsweise nimmt die superhydrophobe nanostrukturierte Oberfläche des Formkörpers die unpolare Flüssigkeit auf, indem letztere an der nanostrukturierten Oberfläche adsorbiert wird. Daher unterscheidet sich die Aufnahme der Flüssigkeit von einer Absorption, bei der diese in das Innere des Formkörpers eindringt. Die selektive Aufnahme der unpolaren Flüssigkeit erfolgt durch die Härchen. Die aufgesammelte Flüssigkeit besteht aufgrund der hohen Hydrophobizität des Formkörpers meist aus der reinen unpolaren Flüssigkeit. Überraschenderweise, ist der Formkörper gleichzeitig superlipophil. Die Härchen auf der Oberkante der Krater nehmen also die unpolare Flüssigkeit selektiv auf und halten sie fest.

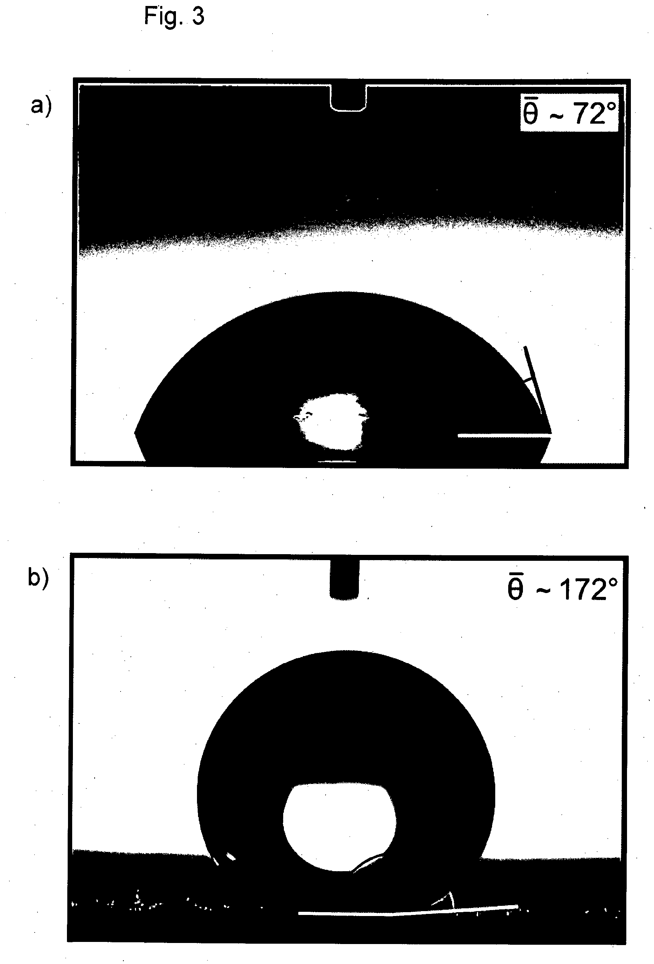

Zwar sind hydrophobe Substanzen oft gleichzeitig lipophil. Überraschenderweise besitzt der Formkörper aber eine äußerst ungewöhnlich hohe Hydrophobizität, und gleichzeitig auch eine äußerst ungewöhnlich hohe Lipophilität. Die Benetzbarkeit des Formkörpers durch unpolare Flüssigkeiten wie Öle und polares Wasser könnte kaum höher sein. Kontaktwinkel von deutlich unterhalb 10° für n-Hexadecan und oberhalb von 170° für Wasser, wie es Fig. 3 zeigt, sind nahe am physikalisch größtmöglichen Unterschied. Andere Sorbenzien besitzen hier ein deutlich nachteiligeres Verhalten, auf das die Wasseraufnahme aller anderen Sorbenzien hinweist. Natürliche Absorber und mineralische Absorber sind zunächst sogar wasserliebend. Durch aufwendige Verfahren kann deren Oberfläche zumindest für kurze Dauer, in den hydrophoben Bereich angehoben werden, jedoch nicht in den superhydrophoben Bereich. Q.F. Wei, R.R. Mather, A.F. Fotheringham, and R.D. Yang. Evaluation of nonwoven poly-propylene oil sorbents in marine oil-spill recovery. Marine Pollution Bulletin, 46(6):780-783, 2003, zeigt, dass selbst Polymermatten aus leicht hydrophobem Polypropylen nehmen noch eine, wenn auch verhältnismäßig geringe, Wassermenge auf. Im Gegensatz zu diesen Matten, die aufgrund ihrer filzartigen Ausgestaltung lediglich eine sehr geringe Ölrückhaltung aufweisen, wird Öl welches an der nanostrukturierten Folie adsorbiert restlos festgehalten. Auch mehrmaliges wiederholtes Eintauchen einer mit Öl benetzten Fläche führt nicht zum Abspülen des Öls. Aufgrund der enormen Hydrophobizität sollte auch enormer Wellengang nicht zu einem Eindringen von Wasser oder Abspülen des Öls führen.

In einer weiteren Ausgestaltung erfolgt das Inkontaktbringen des Formkörpers mit der zu trennenden Mischung durch Eintauchen des Formkörpers in die zu trennende Mischung oder letztere wird direkt auf den Formkörper aufgebracht.

In einer besonderen Ausgestaltung ist die zu trennenden. Mischung eine sichtbare heterogene Mischung aus einer unpolaren Flüssigkeit und einer polaren Flüssigkeit oder eine Emulsion einer unpolaren Flüssigkeit in einer polaren Flüssigkeit ist. Unter einer Emulsion wird ein fein verteiltes Gemisch zweier normalerweise nicht mischbarer Flüssigkeiten ohne sichtbare Entmischung definiert.

Die vorliegende Offenbarung betrifft weiterhin eine Verwendung des Verfahrens zur Trennung einer unpolaren Flüssigkeit von einer polaren Flüssigkeit als Aufnahmeverfahren von Ölschichten auf Wasseroberflächen, wo das Entfernen des Öls aus dem verschmutzen Gewässer sei es Süß- oder Salzwasser auch bei Wellen durch intelligente Ölsperren oder Ölabsauger sogenannte Ölskimmer erfolgen kann. Aufgrund der enormen Hydrophobizität und der völligen Ölrückhaltung sollte auch enormer Wellengang nicht zu einem Eindringen von Wasser oder Abspülen des Öls führen. Weiterhin ist das Verfahren zur Reinhaltung von Gewässern oder zum Entfernen von Öl aus Abwässern oder zur Wiederaufbereitung in Kläranlagen geeignet. Zudem kann das Verfahren zur Aufbereitung von Kühlwasser nach längeren Standzeiten durch Entfernen von Öl aus Kühlmittel eingesetzt werden. Das Verfahren dient auch in der Filtertechnik für Filteranwendungen, wo Emulsionen auf den Formkörper direkt aufgebracht werden und die unpolare Flüssigkeit an der nanostrukturierten Oberfläche adsorbiert wird.

Die Erfindung weist insbesondere die im Folgenden genannten Vorteile auf. Der Verzicht auf Formeinsätze mit einer geometrisch vorbestimmten Struktur erfordert nur einen geringen technischen Aufwand. Das erfindungsgemäße Verfahren ist aufgrund seiner Einfachheit gut skalierbar und damit massentauglich.

Die Verfahrensprodukte weisen eine Oberflächenstrukturierung auf, die bisher nur mittels des vorliegenden Verfahrens erzielbar sind. Insbesondere konnte in Versuchen nachgewiesen werden, dass damit eine Steigerung des Kontaktwinkels um bis zu 100° möglich ist.

Ein besonderer Vorteil bei der Verwendung ist, dass sie wenig aufwändig ist. Durch das Eintauchen des Formkörpers wird an dessen nanostrukturierter Oberfläche die unpolare Flüssigkeit selektiv adsorbiert.

Die unpolare Flüssigkeit, ist deutlich leichter von dem Formkörper zu trennen, um anschließend entsorgt zu werden, als es mit den aus dem Stand der Technik bekannten Absorbenzien der Fall ist.

Ein weiterer Vorteil der vorliegenden Erfindung ist der hohe Unterschied in der Benetzbarkeit des Formkörpers durch unpolare Flüssigkeiten und polare Flüssigkeiten. Parallel zu der hohen Abweisung der polaren Flüssigkeit, welche es ermöglicht keine polare Flüssigkeit aufzunehmen, wird nämlich die unpolare Flüssigkeit adsorbiert und restlos festgehalten. Auch mehrmaliges Eintauchen einer mit unpolarer Flüssigkeit benetzten Oberfläche führt nicht zu einem Abspülen der unpolaren Flüssigkeit.

Die Erfindung wird im Folgenden anhand von Ausführungsbeispielen und den Figuren näher erläutert.

Es zeigen:

Fig. 1    Schematische Darstellung einer bevorzugten Ausführung der erfindungsgemäßen Verfahrensschritte a) bis d);

Fig. 2    **a) bis d)** Mit dem erfindungsgemäßen Verfahren hergestellte Formkörper mit superhydrophoben Oberflächen;

Fig. 3    **a)** Erfindungsgemäß mögliche Umwandlung eines hydrophilen Ausgangsmaterials in ein **b)** Material, das superhydrophobe Kontaktwinkel aufweist, ohne dass dabei eine chemische Modifizierung der Oberfläche stattfindet.

Fig. 4    Aufnahmen der nanostrukturierten Folie vor, während und nach deren Eintauchen in ein mit einer Öl-Wasser-Mischung gefülltes Becherglas.

Fig. 5    Spreitparameter als Funktion der polaren Komponenten der Oberflächenspannung.

Fig. 6    Untersuchungen des Benetzungsverhaltens von Wasser und n-Hexadecan.

Fig. 7    Oberflächenspannung von erprobten Flüssigkeiten und deren dispersiven und polaren Komponenten.

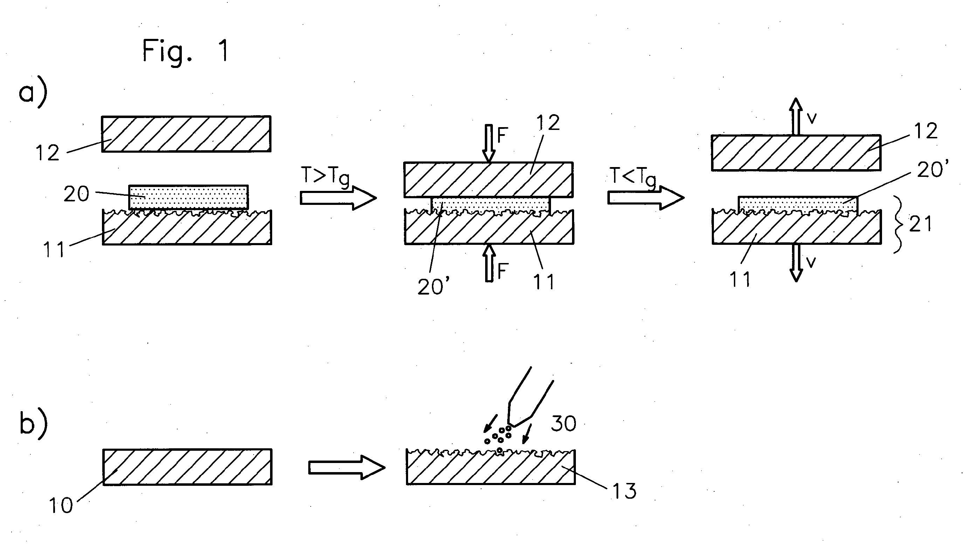

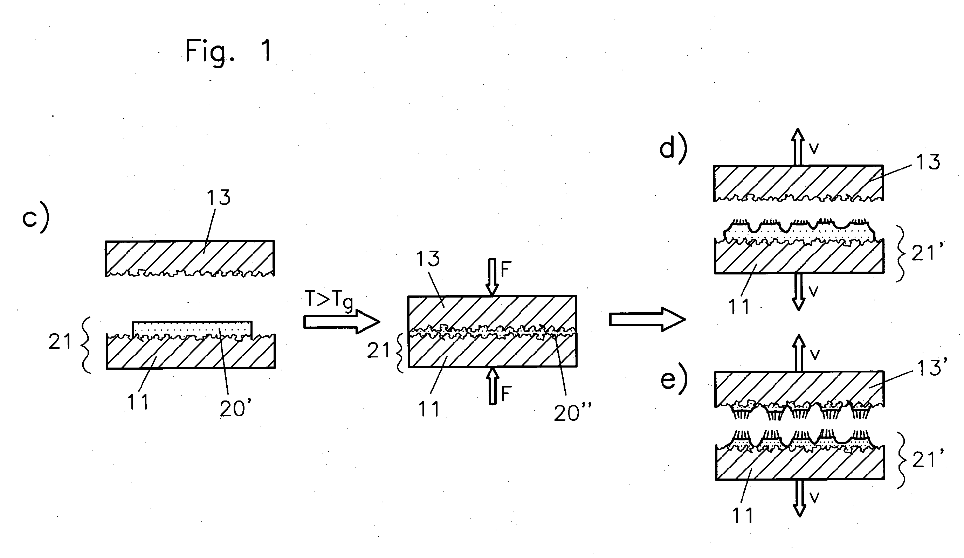

In **Fig. 1** ist das erfindungsgemäße Verfahren schematisch dargestellt. Gemäß **Fig. 1 a)** wird in einer besonders bevorzugten Ausgestaltung des ersten **Verfahrensschritts a)** eine Polymerfolie **20** aus Polycarbonat (PC) zwischen eine erste Platte **11** und eine zweite Platte **12** platziert. Hierbei besitzt die erste Platte **11** aufgrund ihrer rauen Oberfläche eine höhere Haftung gegenüber der Polymerfolie **20**, während die zweite Platte **12** aufgrund ihrer geschliffenen Oberfläche eine geringere Haftung zur Polymerfolie **20** aufweist. Hieran anschließend werden beide Platten **11, 12** auf eine Temperatur oberhalb $T_g$ erhitzt, so dass ein Aufbringen einer Prägekraft **F** das erweichte Polymer derart in die Rauheit der ersten Platte **11** hineinpresst, dass sich ein Verbund **21** aus der ersten Platte **11** mit der darin hineingepressten Polymerfolie **20'** ausbildet, der anschließend entformt wird.

Gemäß **Fig. 1b)** wird in einer besonders bevorzugten Ausgestaltung des zweiten **Verfahrensschritts b)** eine dritte Platte **13** mit einer mittleren Rauheit $R_a'$ von 1 μm bis 20 μm und einer gemittelten Rautiefe $R_z'$ von 30 μm bis 100 μm durch eine Einwirkung von Sandstrahlen **30** auf eine Seite einer bereitgestellten Platte **10** hergestellt.

In **Fig. 1c)** ist **Verfahrensschritt c)** und damit der eigentliche Umformschritt im erfindungsgemäßen Verfahren dargestellt. Hierzu wird die dritte Platte **13** als Formeinsatzplatte gegenüber dem in Verfahrensschritt a) erzeugten Verbund **21** aus der ersten Platte **11** und der darin hineingepressten Polymerfolie **20'** platziert, ohne dass die dritte Platte **13** bereits jetzt den Verbund **21** berührt. Hieran anschließend wird die dritte Platte **13** derart auf eine. Temperatur oberhalb von $T_g$ erwärmt, dass der Verbund **21** selbst nicht erwärmt wird. Sobald nun die heiße dritte Platte **13** als Formeinsatzplatte unter Einwirkung einer Kraft **F** mit der gepressten Polymerfolie **20'** aus dem Verbund **21** in Kontakt, dringt das Polymer aus der gepressten Polymerfolie **20'** teilweise in die bestehenden Rauheiten der dritten Platte **13** ein.

Gemäß **Fig. 1 d)** wird in einem vierten **Verfahrensschritt d)** durch eine Relativbewegung **v** zwischen der ersten Platte **11** aus dem Verbund **21** und der als Formeinsatzplatte dienenden dritten Platte **13** die der dritten Platte zugewandte andere Oberfläche der in die erste Platte **11** hineingepresste Polymerfolie **20'** strukturiert. Entscheidend ist hierbei, dass die hineingepresste Polymerfolie **20'**, die sich im Verbund **21** mit der ersten Platte **11** befindet und daher durch die Relativbewegung mit erfasst wird, während des Entformvorgangs weiterhin erweicht bleibt und sich hierdurch in die Länge ziehen lässt. Auf diese Weise bildet sich ein modifizierter Verbund **21'** aus, der den gewünschten Formkörper enthält. Aufgrund des gewählten Parametersatzes (s. o.) führt der Entformvorgang hier zu einem im Wesentlichen rückstandsfreien Entformen *(Ziehen)*, wodurch dichte, feine Polymerhärchen gezogen werden, die in **Fig. 2a)** zu erkennen sind. Durch ihre geometrische Ausprägung ahmen diese Strukturen den Lotuseffekt nach, wobei auch hierbei gemäß **Fig. 2b)** die charakteristische Kraterstruktur zu erkennen ist.

In **Fig. 1e)** ist eine Variante des vierten **Verfahrensschritts d)** dargestellt, bei der ein anderer Parametersatz gewählt wurde, der zu einem *Auseinanderreißen* der Polymerschicht führt. **Fig. 2c)** zeigt, dass so feine Krater erzeugt werden, an deren Oberkante sich kleinste Polymerhärchen befinden. Diese Strukturen ermöglichen als Funktion der Dichte der Krater zusammen mit der Dichte der sich auf der Oberkante der Krater befindlichen Polymerhärchen eine hohe Haftung der geformten Polymerschicht insbesondere zu Wasser.

**Fig. 2d)** zeigt eine weitere superhydrophobe Oberfläche mit einem weiteren Parametersatz, der zu Kratern führt, an deren Oberkante sich längere Polymerhärchen befinden, die zu einem mittleren Grad an Haftung, der geformten Polymerschicht insbesondere zu Wasser führen.

**Fig. 3** belegt, dass mit dem vorliegenden Verfahren selbst für hydrophile Ausgangsmaterialien, wie hier Polycarbonat (PC), superhydrophobe Kontaktwinkel erhalten werden, ohne dass hierzu eine chemische Modifizierung der Oberfläche erforderlich ist. **Fig. 3a)** zeigt, wie ein Tropfen auf einer hydrophilen Oberfläche aus Polycarbonat einen Kontaktwinkel von ca. 72° ausbildet.

Mit einer mit dem erfindungsgemäßen Verfahren durchgeführten Strukturierung wurde ein Formköper erhalten, der an seiner nun strukturierten Oberfläche, ohne dass hierzu eine Behandlung mit chemischen Substanzen erfolgte, superhydrophobe Eigenschaften aufweist. Diese zeigen sich, wie in **Fig. 3b)** dargestellt, insbesondere im beobachteten Kontaktwinkel von ca. 172°.

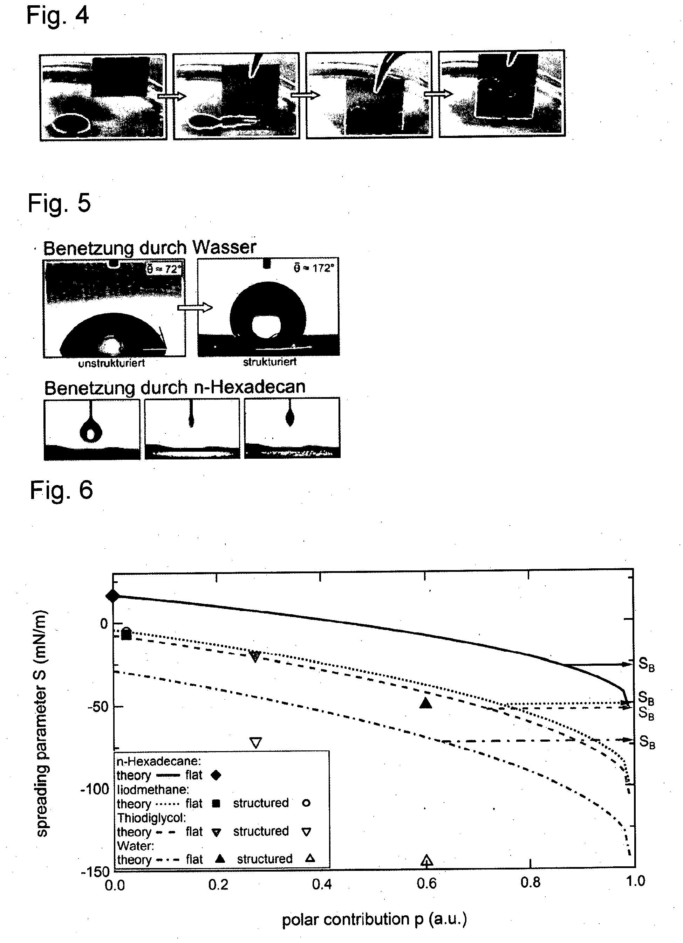

Fig. 4 zeigt Aufnahmen der nanostrukturierten Folie vor, während und nach deren Eintauchen in ein mit einer Öl-Wasser-Mischung gefülltes Becherglas. Das Wasser wird abgewiesen, während das Öl auf der Folie selektiv adsorbiert wird.

Fig. 5 stellt den Spreitparameter als Funktion der polaren Komponenten der Oberflächenspannung dar. Die theoretische Spreitparameter (Linien) sind aufgezeigt für 4 verschiedene Oberflächenspannungen. Gemessene Daten für die unstrukturierte Polycarbonatfolie: ausgefüllte Zeichen (Diiodmethan: ■, Thioglycol: ▼ und Wasser: ▲), für die nanostrukturierte Polycarbonatfolie: die entsprechenden leeren Zeichen außer für Diiodmethan: o. Der theoretische Wert des Spreitparameters für n-Hexadecan auf die unstrukturierte Polycarbonatfolie ist als Raute ♦ markiert.

Fig. 6 zeigt die Untersuchung der Benetzungsverhaltens von Wasser und n-Hexadecan. Durch Anwendung des Strukturgebungsverfahrens wird die strukturierte Polymerfolie wasserabweisend. Aufgegebenes n-Hexadecan spreitet jedoch an der strukturierten Polymerfolie und benetzt sie völlig. Es wurden Kontaktwinkel von deutlich unterhalb 10° für n-Hexadecan und oberhalb von 170° für Wasser gemessen, welche nahe am physikalisch größtmöglichen Unterschied sind.

Ausführungsbeispiel 1:

Zur Trennung mittels der superhydrophoben Folie wurde mit Ölfarbe gefärbtes Öl in einen Glasbecher mit Wasser gegeben. Anschließend wurde eine Folie in die Öl-Wasser Mischung eingetaucht und wieder herausgezogen. Das Experiment wurde mit verschiedenen unpolaren Flüssigkeiten durchgeführt (n-Hexadecan und Hydrauliköl "Total Azolla ZS 10"). Wie aus Fig. 4 zu entnehmen ist, wird das Öl durch die nanostrukturierte Folie adsorbiert. Das gefärbte Öl steigt über den Wasserpegel auf. Beim Entnehmen der Folie wird das Öl an der strukturierten Folie durch die Härchen festgehalten und wird somit vom Wasser getrennt. Das Wasser wird fast ausschließlich abgewiesen. Eine Öl-Aufnahme von bis zu 150 mL/m2 wurde gemessen und zwar mit "Total Azolla ZS 10".

Ausführungsbeispiel 2:

In diesem Ausführungsbeispiel wurde einen Emulsion von orangegefärbtem Öl in blauem Farbwasser auf eine geneigte nanostrukturierte Folie und auf die unstrukturierte Folie aufgebracht. Die aufgebrachte Emulsion entmischt sich nicht auf der unstrukturierten Oberfläche in der Zeit, wo diese auf der Folie hinunterläuft. Das Öl benetzt die unstrukturierte Oberfläche und der Rest der Emulsion gleitet auf der Folie ohne Entmischung weiter. Anders verläuft es bei der nanostrukturierten Folie, auf der sich die Emulsion entmischt, da das Öl adsorbiert wird und von den Nanohärchen eingesperrt wird, während das Wasser abperlt. Das Wasser wird dadurch gereinigt.

Für die Oberflächenspannung von dem unstrukturierten Polycarbonat wurde ein Wert $\gamma_{SV}$ = 46,78 mN/m gemessen mit klarer Überhand von den dispersiven Interaktionen (46,76 mN/m und 0,02 mN/m).

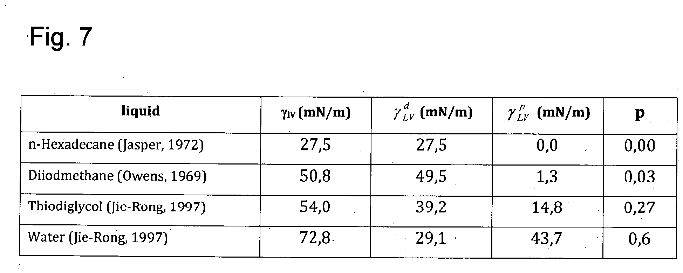

Fig. 5 zeigt den Spreitparameter von der unstrukturierten Polycarbonatfolie abhängig von der polaren Komponente für verschiedene Oberflächenspannungen. Die ausgewählten Oberflächenspannungen entsprechen den Flüssigkeiten, die in Fig. 7 aufgelistet. Der Spreitparameter und demnach auch die Benetzbarkeit gehen mit steigender Oberflächenspannung der Flüssigkeit zurück. Interessanterweise beeinflusst der Polaritätsanteil den Spreitparameter noch deutlicher. Mit steigenden polaren Interaktionen im Gegenzug zu dispersive Interaktionen sinkt der Spreitparameter exponentiell. Die Verteilung der dispersiven und polaren Komponenten haben einen starken Einfluss auf das unstrukturierte Polycarbonat.

Die Spreitparameter für Diiodemethan, Thioglycol und Wasser wurden errechnet durch Einsetzen der gemessenen statischen Kontaktwinkel in die Youngsche Gleichung [9]. Die Lösung der Gleichung ergab den Wert für $\gamma_{SL}$. Gemäß der Gleichung zur Bestimmung der Spreitparameter wurden diese errechnet und in Fig. 4B hinzugefügt (Vierecke nach Farben: Diiodmethan: rot, Thiodiglycol: grün, Wasser: blau). Interessanterweise gleichen sich die errechneten Daten den theoretischen Werten (Linien) sehr gut an. Des weiteren wird der theoretische Spreitparameter für n-hexadecan durch ein braune Raute angezeigt. Die Tatsache, dass alle Datenpunkte sich weit über den Spreitparametern bei Randbedigung Sb befinden, zeigt dass alle erprobten Flüssigkeiten die unstrukturierte Polycarbonatfolie benetzen.

Für das nanostrukturierte Substrat ($\gamma SV$ = 122,65 mN/m; 63,73 mN/m und 58,92 mN/m) wurden die Spreitparameter der getesteten Flüssigkeiten analog gemessen (Kreise). Interessanterweise entsprachen die Veränderungen im Streitparameter der polaren Komponente der Oberflächenspannung. Der Spreitparameter des quasi unpolaren Diiodmethans ist leicht angestiegen, wobei der Spreitparameter für die Flüssigkeiten mit höherer Polarität sprich Thiodiglycol und Wasser im Vergleich zu den Werten hinsichtlich der unstrukturierten Polycarbonatfolie abnahm. Mit steigender polarem Beitrag, wurde die Änderung bezüglich des Spreitparameters grösser. Die Spreitparameter für Thiodiglycol und Wasser sind sogar unter dem entsprechenden Spreitparameter bei Randbedingung $S_b$ und somit ist die unstrukturierte Folie deutlich in einem unbenetzbaren Zustand. Folglich benetzen die quasi unpolaren Flüssigkeiten die nanostrukturierte Folie sogar mehr als die polaren Flüssigkeiten abgewiesen werden. Demzufolge neigt das unpolare Öl dazu, die nanostrukturierte Folie zu benetzen, wohingegen polare Flüssigkeiten wie Wasser abgewiesen werden. Dies ermöglicht die Öl-Wasser Trennung durch die nanostrukturierte Folie.

**Patentansprüche**

1. Verfahren zur Herstellung eines Formkörpers mit den Verfahrensschritten

   a) Bereitstellen eines Verbunds (21) aus einer ersten Platte (11) mit einer in eine Oberfläche der ersten Platte (11) eingepressten Polymerfolie (20'),
   b) Bereitstellen einer dritten Platte (13), die zumindest teilweise auf einer ihrer Oberflächen Rauheiten aufweist, die eine mittlere Rauheit $R_a$ von 1 $\mu$m bis 30 $\mu$m und eine gemittelten Rautiefe $R_z$ von 20 $\mu$m bis 100 $\mu$m besitzen,
   c) Platzieren der dritten Platte (13) gegenüber der eingepressten Polymerfolie (20'), ohne dass die dritte Platte (13) den Verbund (21) berührt,
   anschließendes Erwärmen der dritten Platte (13) auf eine Temperatur oberhalb der Glasübergangstemperatur $T_g$ des in der Polymerfolie (20') enthaltenen Polymers, ohne dass der Verbund (21) erwärmt wird, und Inkontaktbringen der erwärmten dritten Platte (13) mit der der ersten Platte abgewandten Oberfläche der Polymerfolie (20'), wodurch das Polymer aus der Polymerfolie (20') zumindest teilweise in die Rauheiten der dritten Platte (13) eindringt,
   d) Strukturieren der der dritten Platte (13) zugewandten Oberfläche der eingepressten Polymerfolie (20') durch eine Relativbewegung, die die dritte Platte (13) von der ersten Platte (11) entfernt, solange die eingepresste Polymerfolie (20') erweicht bleibt und sich hierdurch in die Länge ziehen lässt, wodurch sich ein modifizierter Verbund (21'), der den gewünschten Formkörper umfasst, ausbildet.

2. Verfahren nach Anspruch 1, wobei der Verbund (21) aus der ersten Platte (11) mit der in eine Oberfläche der ersten Platte (11) eingepressten Polymerfolie (20') erzeugt wird durch Einbringen einer Polymerfolie (20) zwischen die erste Platte (11) und eine zweite Platte (12), die derart ausgestaltet sind, dass die erste Platte (11) eine höhere Haftung gegenüber der Polymerfolie (20) im Vergleich zur zweiten Platte (12) aufweist, und anschließendes Erwärmen der beiden Platten (11, 12) auf eine Temperatur oberhalb der Glasübergangstemperatur $T_g$, wodurch das erweichte Polymer unter Aufbringen einer Prägekraft derart an die erste Platte (11) gepresst wird, dass sich der Verbund (21) aus der ersten Platte (11) mit der darin eingepressten Polymerfolie (20') ausbildet.

3. Verfahren nach Anspruch 1 oder 2, wobei die Rauheiten der dritten Platte (13) durch Behandlung mindestens einer Oberfläche einer unbehandelten dritten Platte (10) mittels Beaufschlagung durch Partikel.

4. Verfahren nach Anspruch 3, wobei die Rauheiten der dritten Platte (13) mittels Beaufschlagung mindestens eines Teils einer Oberfläche der unbehandelten dritten Platte (10) durch Sandstrahlen erzeugt werden.

5. Verfahren nach einem der Ansprüche 1 bis 4, wobei auf der dritten Platte (13) zumindest teilweise auf einer ihrer Oberflächen Rauheiten erzeugt werden, die eine mittlere Rauheit $R_a$' von 1 $\mu$m bis 20 $\mu$m und eine gemittelten Rautiefe $R_z$' von 30 $\mu$m bis 100 $\mu$m aufweisen.

6. Verfahren nach einem der Ansprüche 1 bis 5, wobei das Strukturieren der der dritten Platte (13) zugewandten Oberfläche der eingepressten Polymerfolie (20') durch ein vollständiges Abziehen der eingepressten Polymerfolie (20') von der noch erwärmten dritten Platte (13) erfolgt.

7. Verfahren nach einem der Ansprüche 1 bis 5, wobei das Strukturieren der der dritten Platte (13) zugewandten Oberfläche der eingepressten Polymerfolie (20') erfolgt, indem durch ein Abreißen der eingepressten Polymerfolie (20') von der noch erwärmten dritten Platte (13) Teile der Polymerfolie (20') an der dritten Platte (13) haften bleiben, die nicht Bestandteil des modifizierten Verbunds (21') , der den gewünschten Formkörper umfasst, sind.

8. Verfahren nach einem der Ansprüche 1 bis 7, wobei die erste Platte (11) und/oder die zweite Platte (12) und/oder die dritte Platte (13) in Form einer Walze ausgestaltet sind.

**Claims**

1. Method for producing a shaped body with the method steps:

   a) providing a composite (21) from a first plate (11), having a polymer film (20') pressed into the surface of the first plate (11),
   b) providing a third plate (13), which has rough areas at least in part on one of its surfaces, which have a mean roughness $R_a$ of 1 $\mu$m to 30 $\mu$m and averaged roughness depth $R_z$ of 20 $\mu$m to 100 $\mu$m,
   c) placing the third plate (13) opposite the pressed-in polymer film (20'), without the third plate (13) touching the composite (21), followed by the heating of the third plate (13) to a temperature above the glass transition temperature $T_g$ of the polymer contained in the polymer film (20'), without the composite (21) being heated, and the heated third plate (13) is brought into contact with the surface of the polymer film (20') facing away from the first plate, wherein the polymer from the polymer film (20') penetrates partially into the rough areas of the third plate (13),
   d) structuring the surface of the pressed-in polymer film (20') facing the third plate (13) by way of a relative movement which distances the third plate (13) from the first plate (11) so long as the pressed-in polymer film (20') remains softened and in this way can be drawn out in length, as a result of which a modified composite (21') is formed, which comprises the required shaped body.

2. Method according to claim 1, wherein the composite (21) is produced from the first plate (11), with the polymer film (20') pressed into a surface plate (11), by the introduction of a polymer (20) between the first plate (11) and a second plate (12), which are configured in such a way that the first plate (11) exhibits a higher degree of adhesion in relation to the polymer film (20) in comparison with the second plate (12), and subsequent heating of both the plates (11, 12) to a temperature above the glass transition temperature $T_g$, as a result of which the softened polymer is pressed onto the first plate (11), with the application of an embossing force, in such a way that the composite (21) is formed from the first plate (11), with the polymer film (20') pressed into it.

3. Method according to claim 1 or 2, wherein the rough areas of the third plate (13) are produced by treatment of at least one surface of an untreated third plate (10) by the imposition of particles.

4. Method according to claim 3, wherein the rough areas of the third plate (13) are produced by the imposition of sandblasting on at least a part of a surface of the untreated third plate (10).

5. Method according to any one of claims 1 to 4, wherein the rough areas are produced on the third plate (13) at least in part on one of its surfaces, which exhibit a mean roughness $R_a$' of 1 $\mu$m to 20 $\mu$m and an averaged roughness depth $R_z$' of 30 $\mu$m to 100 $\mu$m.

6. Method according to any one of claims 1 to 5, wherein the structuring of the surface of the pressed-in polymer film (20') facing the third plate (13) is carried out by a complete drawing of the pressed-in polymer film (20') off from the still heated third plate (13).

7. Method according to any one of claims 1 to 5, wherein the structuring of the surface of the pressed-in polymer (20') facing the third plate (13) takes place in that, by the tearing of the pressed-in polymer film (20') away from the still heated third plate (13), parts of the polymer film (20') remain adhering to the third plate (13), which are not constituent parts of the modified composite (21') which comprises the desired shaped body.

8. Method according to any one of claims 1 to 7, wherein the first plate (11) and/or the second plate (12) and/or the third plate (13) are configured in the form of a roller.

**Revendications**

1. Procédé de réalisation d'un élément à façonner comprenant les étapes suivantes consistant à :

a) fournir une combinaison (21) d'une première plaque (11) et d'un film de polymère (20') pressé dans la surface de la première plaque (11),

b) fournir une troisième plaque (13) qui présente au moins en partie des rugosités sur l'une de ses surfaces et qui ont une rugosité moyenne $R_a$ comprises entre 1 $\mu$m et 30 $\mu$m et une profondeur moyenne de rugosité $R_z$ comprise entre 20 $\mu$m et 100 $\mu$m,

c) placer la troisième plaque (13) par rapport au film de polymère pressé (20') sans que la troisième plaque (13) ne touche la combinaison (21), ensuite chauffer la troisième plaque (13) à une température supérieure à la température de transition vitreuse $T_g$ du polymère contenu dans le film de polymère (20') sans chauffer la combinaison (21) et mettre en contact la troisième plaque (13) chauffée avec la surface du film de polymère (20') opposée à la première plaque de façon que le polymère du film de polymère (20') pénètre au moins partiellement dans les rugosités de la troisième plaque (13),

d) structurer la surface du film de polymère (20') pressé, tourné vers la troisième plaque (13) par un mouvement relatif qui éloigne la troisième plaque (13) par rapport à la première plaque (11) aussi longtemps que le film de polymère (20'), pressé reste ramolli et peut ainsi être étiré en longueur de façon à développer une combinaison modifiée (21') qui correspond à l'élément façonné souhaité.

2. Procédé selon la revendication 1,
selon lequel
on réalise la combinaison (21) de la première plaque (11) avec le film de polymère (20') pressé dans la surface de la première plaque (11) en introduisant un film de polymère (20) entre la première plaque (11) et une seconde plaque (12) qui sont conçues de façon que la première plaque (11) présente un accrochage plus élevé vis-à-vis du polymère (20) que la seconde plaque (12) et ensuite chauffage des deux plaques (11, 12) à une température supérieure à la température de transition vitreuse $T_g$ de façon que le polymère ramolli soumis à une force d'impression soit pressé dans la première plaque (11) pour développer la combinaison (21) formée de la première plaque (11) et du film de polymère (20') pressé dans celle-ci.

3. Procédé selon la revendication 1 ou 2,
selon lequel
la rugosité de la troisième plaque (13) est obtenue par un traitement d'au moins une surface d'une troisième plaque (10) non traitée, en lui appliquant des particules.

4. Procédé selon la revendication 3,

selon lequel
on génère les rugosités de la troisième plaque (13) par le sablage d'au moins sur une partie de la surface de la troisième plaque (10) non traitée.

5. Procédé selon l'une des revendications 1 à 4,
selon lequel
on génère sur la troisième plaque (13) au moins en partie sur l'une de ses surfaces, des rugosités qui ont une rugosité moyenne $R_a'$ comprise entre 1 $\mu$m et 20 $\mu$m et une profondeur de rugosité moyenne $R_z'$ comprise entre 30 $\mu$m et 100 $\mu$m.

6. Procédé selon l'une des revendications 1 à 5,
selon lequel
on structure la surface de film de polymère (20') pressé dans la troisième plaque (13) en regard, en enlevant complètement le film de polymère pressé (20') de la troisième plaque (13) encore chaude.

7. Procédé selon l'une des revendications 1 à 5,
selon lequel
on structure la surface tournée vers la troisième plaque (13) du film de polymère (20') pressé, en ce qu'en arrachant le film de polymère (20') pressé de la troisième plaque (13) encore chaude, des parties du film de polymère (20') restent accrochées à la troisième plaque (13) et qui ne font pas partie de la combinaison modifiée (21') qui comprend l'élément façonné souhaité.

8. Procédé selon l'une des revendications 1 à 7,
selon lequel
la première plaque (11) et/ou la seconde plaque (12) et/ou la troisième plaque (13) sont sous la forme d'un cylindre.

## Fig. 1

a)

b)

EP 2 919 966 B1

Fig. 1

EP 2 919 966 B1

Fig. 2

a)

b)

## Fig. 2

c)

50 µm

d)

50 µm

Fig. 3

a)

$\bar{\theta} \sim 72°$

b)

$\bar{\theta} \sim 172°$

## Fig. 4

## Fig. 5

Benetzung durch Wasser

unstrukturiert                strukturiert

Benetzung durch n-Hexadecan

## Fig. 6

polar contribution p (a.u.)

## Fig. 7

| liquid | $\gamma_{lv}$ (mN/m) | $\gamma_{LV}^{d}$ (mN/m) | $\gamma_{LV}^{p}$ (mN/m) | p |
|---|---|---|---|---|
| n-Hexadecane (Jasper, 1972) | 27,5 | 27,5 | 0,0 | 0,00 |
| Diiodmethane (Owens, 1969) | 50,8 | 49,5 | 1,3 | 0,03 |
| Thiodiglycol (Jie-Rong, 1997) | 54,0 | 39,2 | 14,8 | 0,27 |
| Water (Jie-Rong, 1997) | 72,8 | 29,1 | 43,7 | 0,6 |

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008053619 A1

**In der Beschreibung aufgeführte Nicht-Patentliteratur**

- **W. BARTHLOTT ; C. NEINHUIS.** Purity of the sacred lotus, or escape from contamination in biological surfaces. *Planta,* 1997, vol. 202, 1
- **B. BHUSHAN ; E.K. HER.** Fabrication of Superhydrophobic Surfaces with High and Low Adhesion Inspired from Rose Petal. *Langmuir,* 2010, vol. 26 (11), 8207
- **NACH A.R. PARKER ; C.R. LAWRENCE.** Water capture by a desert beetle. *Nature,* 2001, vol. 414, 33
- **J. BEKESI ; J.J.J. KAAKKUNEN ; W. MICHAELI ; F. KLAIBER ; M. SCHOENGART ; J. IHLEMAHN ; P.SIMON.** Fast fabrication of super-hydrophobic surfaces on polypropylene by replication of short-pulse laser structured molds. *Appl. Phys.,* 2010, vol. A 99, 691
- **U. FISCHER et al.** Tabellenbuch Metall. Verlag Europa-Lehrmittel, 2002, vol. 41
- **W. BEITZ ; K.-H. GROTE.** Dubbel Taschenbuch für den Maschinenbau. Springer-Verlag Berlin, 1997, vol. 19
- **JUUSO T. KORHONEN ; MARJO KETTUNEN ; ROBIN H. A. RAS ; OLLI IKKALA.** Hydrophobic nanocellulose aero-gels as floating, sustainable, reusable, and recyclable oil absorbents. *ACS Appl. Mater. Interfaces,* 2011, vol. 3 (6), 1813-1816
- **A. VENKATESWARA RAO ; NAGARAJA D. HEGDE ; HIROSHI HIRASHIMA.** Absorption and desorption of organic liquids in elastic superhydrophobic silica aerogels. *Journal of Colloid and Interface Science,* 2007, vol. 305 (1), 124-132
- **XINWEI CHEN ; LIANG HONG ; YANFANG XU ; ZHENG WEI ONG.** Ceramic pore channels with inducted car-bon nanotubes for removing oil from water. *ACS Applied Materials & Interfaces,* 2012, vol. 4 (4), 1909-1918
- **M.O. ADEBAJO ; R.L. FROST ; J.T. KLOPRÖGGE ; O. CARMODY ; S. KOKOT.** Porous materials for oil spill cleanup: A review of synthesis and absorbing properties. *Journal of Porous Materials,* 2003, vol. 10, 159-170
- **D. K. OWENS ; R. C. WENDT.** Estimation of the surface free energy of polymers. *Journal of Applied Polymer Science,* 1969, vol. 13 (8), 1741-1747
- **BEREICH. Q.F. WEI ; R.R. MATHER ; A.F. FOTHERINGHAM ; R.D. YANG.** Evaluation of nonwoven poly-propylene oil sorbents in marine oil-spill recovery. *Marine Pollution Bulletin,* 2003, vol. 46 (6), 780-783